Europäisches Patentamt

(19) European Patent Office

Office européen des brevets

(11) Publication number: **0 020 717**
**B1**

(12) **EUROPEAN PATENT SPECIFICATION**

(45) Date of publication of patent specification: **20.07.83**

(51) Int. Cl.³: **H 03 K 3/023**

(21) Application number: **80900122.5**

(22) Date of filing: **05.12.79**

(86) International application number:
**PCT/US79/01053**

(87) International publication number:
**WO 80/01345 26.06.80 Gazette 80/14**

(54) **INTERVAL TIMER CIRCUIT.**

| | |
|---|---|
| (30) Priority: **18.12.78 US 970769** | (73) Proprietor: NCR Corporation<br>**World Headquarters**<br>**Dayton Ohio 45479 (US)** |
| (43) Date of publication of application:<br>**07.01.81 Bulletin 81/1** | (72) Inventor: DULEY, Raymond Stephen<br>**9510 Woodwyck Court**<br>**Spring Valley, OH 45370 (US)** |
| (45) Publication of the grant of the patent:<br>**20.07.83 Bulletin 83/29** | |
| (84) Designated Contracting States:<br>**DE FR GB** | (74) Representative: Robinson, Robert George<br>**International Patent Department NCR Limited 206**<br>**Marylebone Road**<br>**London NW1 6LY (GB)** |
| (56) References cited:<br>**DE - A - 2 236 209**<br>**DE - A - 2 647 569**<br>**DE - B - 1 295 633**<br>**US - A - 3 693 030**<br>**US - A - 3 694 772**<br>**US - A - 3 794 934**<br>**US - A - 3 838 351**<br>**US - A - 3 854 105**<br>**US - A - 3 889 197**<br>**US - A - 3 916 342**<br>**US - A - 4 012 645** | (56) References cited:<br>**ELECTRONIC EQUIPMENT NEWS, vol. 14, no. 8,**<br>**December 1972, London GB RIGNALL: "The**<br>**operational amplifier as a relaxation oscillator",**<br>**pages 49—51** |

Interval timer circuit

## Technical field

This invention relates to an interval timer circuit.

## Background art

A typical prior-art, interval timer circuit is of the type LM555 which is manufactured by a plurality of integrated circuit manufacturers, with one such circuit, for example, being manufactured by Texas Instruments Corporation.

While these prior art interval timer circuits perform satisfactorily, they do require two comparators (to determine the frequency of oscillation), an output buffer, a flip-flop, and several resistors. Generally, one comparator is used for sensing the higher threshold voltage and the remaining one is used for sensing the lower threshold voltage.

In U.S. Patent No. 3,794,934 there is disclosed an R.C. oscillator circuit including a differential amplifier which is arranged to be switched between first and second states, means being provided for establishing at a first input of the amplifier a first reference voltage or a second reference voltage dependent on the state of the amplifier. A second input of the differential amplifier is coupled to a charging capacitor, and when the amplifier is in said second state the capacitor charges until the voltage at the second input exceeds the first reference voltage, whereupon the amplifier switches to its first state. When the differential amplifier is in said first state, the capacitor discharges until the voltage at the second input is less than the second reference voltage, whereupon the differential amplifier switches back to said second state. A disadvantage of this oscillator circuit is that its output frequency is dependent on the supply voltage.

## Disclosure of the invention

It is an object of the present inention to provide an interval timer circuit which is more simple and less expensive compared with prior art interval timer circuits, and whose output frequency remains constant even with some variation in the supply voltage.

According to the present invention there is provided an interval timer circuit including a comparator having first and second inputs thereto and an output therefrom; a circuit network comprising first and second resistive means and capacitive means series connected between a source of potential and reference ground, with a junction between said second resistive means and said capacitive means being coupled to said second input; first means for establishing a first reference voltage at said first input whereby the output of said comparator changes from a second state to a first state when a voltage progressively changing in one sense at said second input traverses said first reference voltage, said first means comprising third and fourth resistive means series connected between the source of potential and said reference ground with the junction between said third and fourth resistive means being connected to said first input; second means responsive to said first state of said output for establishing a second reference voltage at said first input; and third means for producing at said second input in response to said first state a voltage which changes progressively in a sense opposite to said one sense towards said second reference voltage whereby the output of said comparator changes to said second state when the voltage at said second input traverses said second reference voltage; characterized in that said second means comprises fifth resistive means and first diode means series connected between said first input and said output; and said third means comprises second diode means connected between said output and a junction between said first and second resistive means, whereby the output frequency of the interval timer circuit remains constant even with some variation in the source of potential.

## Brief description of the drawings

One embodiment of the invention will now be described by way of example with reference to the accompanyinl drawings, in which:

Fig. 1 is a schematic diagram of an interval timer circuit in accordance with the invention;

Fig. 2A is a waveform showing the voltage at a control point (A) within the circuit shown in Fig. 1; and

Fig. 2B is a waveform showing the output from the circuit shown in Fig. 1.

## Best mode for carrying out the invention

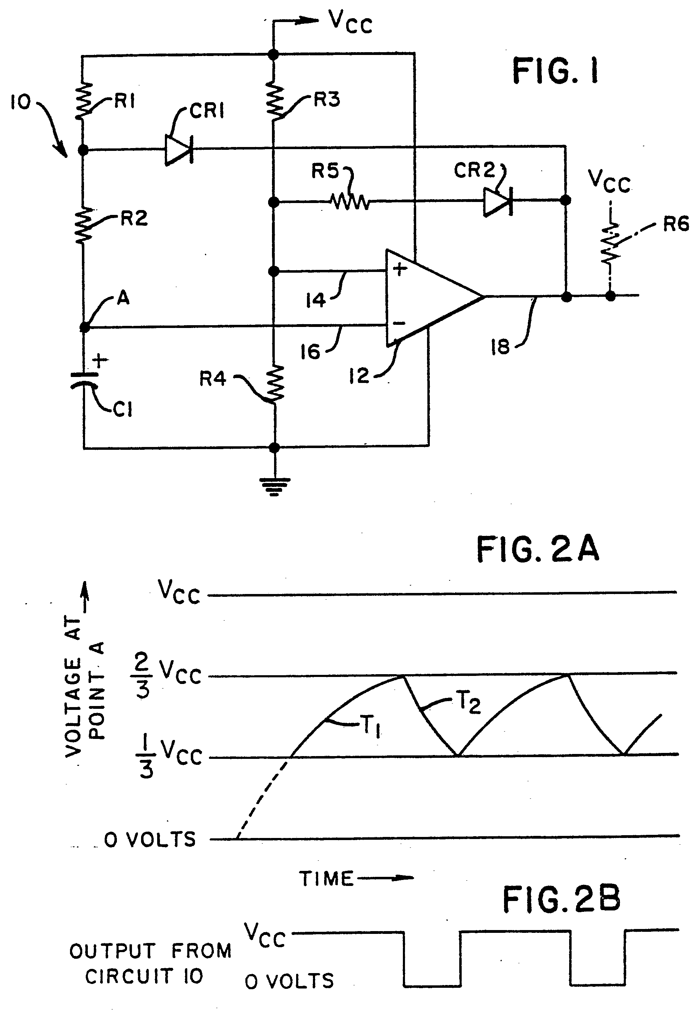

Fig. 1 is a schematic diagram of a preferred embodiment of the interval timer circuit of this invention which is designated generally as 10.

The circuit 10 includes a comparator 12 having first and second inputs 14 and 16, respectively, thereto, and an output 18 therefrom. The comparator 12 may be of the open or non-open collector variety. An example of an open-collector comparator 12 is I.C. circuit chip LM339 which is manufactured by National Semiconductor Corp. Comparator 12 has the usual connections to a source of potential (VCC) and system ground.

The circuit 10 also includes a control means for varying the voltage at second input 16 comprising a circuit network including resistors R1 and R2 and capacitor C1 which are series connected to form a circuit leg which is connected across the VCC potential and the system ground of the circuit 10. A control point A located at the junction of resistor R2 and capacitor C1 is connected to the second input 16 of the comparator 12. The remaining end of capacitor C1 is connected to system ground.

A first means for establishing a first reference voltage at the first input 14 of the comparator 12 includes a voltage divider network consisting of series-connected resistors R3 and R4, with the network being connected across the VCC potential and the system ground. The junction between resistors R3 and R4 is connected to the first input 14 of the comparator 12.

The circuit 10 also includes a second means for establishing a second reference voltage at the first input 14 of the comparator 12, which second means includes said resistor R4, a resistor R5 and a diode CR2 which are series connected across the first input 14 and the output 18 of the comparator 12, with the cathode of this diode being connected to the output 18.

A third means comprising a diode CR1 having its anode connected to the junction between resistors R1 and R2 and its cathode connected to the output 18 of the comparator 12 provides a means for producing a decreasing voltage at control point A as will be described hereinafter.

The operation of the circuit 10 is as follows: When the VCC voltage is turned on, the capacitor C1 will begin to be charged exponentially via the resistors R1 and R2 and, consequently, the voltage at control point A will begin to increase towards the VCC voltage. The output of the comparator 12 at this time will be in a second state which represents the high impedance level with the first state representing the low impedance or conducting state.

When the comparator 12 is of the open collector variety, a pull up resistor R6 (shown in dashed outline in Fig. 1) may be utilized to drive the output 18 of the circuit 10 to the VCC potential. If the comparator 12 is of the non-open collector type, the resistor R6 may be eliminated.

In a preferred embodiment of this invention, the resistors R3, R4 and R5 are in the ratio of 6:12:4; consequently, the first reference voltage at the first input 14 of the comparator 12 will be set at 2/3 VCC, as the resistor R5 does not affect the circuit at this time due to the fact that the output 18 is in the high impedance state and diode CR2 is nonconducting at this time.

As the voltage level at control point A increases due to the positive charging of capacitor C1, the output 18 of the comparator 12 will change from its second state to its first or low impedance state when the voltage level at control point A is greater than the first reference voltage (2/3 VCC) at the first input 14 of the comparator 12.

When the output 18 of the comparator 12 changes from its second state to its first state, which is essentially at reference ground, three situations occur, namely:

(1) The output of the circuit 10 from comparator 12 switches from a high voltage level to a low voltage level;

(2) Diode CR2 conducts causing resistor R5 to be switched into the circuit 10, causing the voltage at the first input 14 to drop to a second reference level of 1/3 VCC; in effect, the combination of resistor R5 and diode CR2 is coupled in parallel with resistor R4; and

(3) The diode CR1 conducts, causing the charge stored across capacitor C1 to discharge exponentially towards reference ground via the resistor R2 and the diode CR1, thereby causing a decreasing voltage at control point A.

When the decreasing voltage at control point A is less than the second reference level (1/3 VCC) at the first input 14, the comparator 12 detects this difference, causing its output to change from the first state to the second or high impedance state. When the output 18 of the comparator 12 changes to the second state, the diodes CR1 and CR2 become nonconducting, thereby interrupting the current flow through resistor R5, permitting the voltage level at the first input 14 of the comparator 12 to rise to the first reference level (2/3 VCC) and also permitting capacitor C1 to charge in a positive direction, whereby the process just described is repeated to produce the output shown in Fig. 2B.

Fig. 2A shows the voltage level at control point A, with $T_1$ representing the time period for charging the capacitor C1 from 1/3 VCC to 2/3 VCC, and with $T_2$ representing the time period for discharging the capacitor C1 from 2/3 VCC to 1/3 VCC. With regard to time periods $T_1$ and $T_2$, a time period is determined by the general formula: $T = RC$; and specifically,

$$T_1 = 0.6931 \ (R1 + R2) \ C1; \text{ and}$$
$$T_2 = 0.6931 \ (R2) \ C1$$

The output frequency of the circuit 10 is as follows:

$$\text{freq. output} = \frac{1}{T_1 + T_2}.$$

In a typical application of the circuit 10, with resistors R1 and R2 being equal to 10K and 20K ohms, respectively, and with the capacitor C1 equal to 0.01 $\mu$F, a square wave output frequency of 2.88 Khz is achieved at output 18 of the circuit 10. The resistors R3, R4, and R5 typically may be 6K, 12K and 4K ohms, respectively.

The output frequency of the circuit 10 remains constant even with some variation in the VCC voltage.

## Claims

1. An interval timer circuit including a comparator (12) having first (14) and second (16) inputs thereto and an output (18) therefrom; a circuit network comprising first (R1) and second (R2) resistive means and capacitive means (C1) series connected between a source of potential and reference ground, with a junction between said second resistive means and said capacitive means being coupled to said second input (16); first means (R3, R4) for establishing a first reference voltage at said first input (14) whereby the output of said comparator (12) changes from a second state to a first state when a voltage progressively changing in one sense at said second input (16) traverses said first reference voltage, said first means comprising third (R3) and fourth (R4) resistive means series connected between the source of potential and said reference ground with the junction between said third and fourth resistive means being connected to said first input (14); second means (R5, CR2) responsive to said first state of said output for establishing a second reference voltage at said first input (14); and third means (CR1) for producing at said second input (16) in response to said first state a voltage which changes progressively in a sense opposite to said one sense towards said second reference voltage whereby the output of said comparator (12) changes to said second state when the voltage at said second input traverses said second reference voltage; characterized in that said second means comprises fifth resistive means (R5) and first diode means (CR2) series connected between said first input and said output (18), and said third means comprises second diode means (CR1) connected between said output and a junction between said first (R1) and second (R2) resistive means, whereby the output frequency of the interval timer circuit remains constant even with some variation in the source of potential.

2. A circuit according to claim 1, characterized in that said third (R3), fourth (R4) and fifth (R5) resistive means have resistive values which are in the ratio 6:12:4.

## Patentansprüche

1. Intervall-Zeitgabe-Schaltung mit einem Vergleicher (12), der einen ersten (14) und zweiten (16) Eingang und einen Ausgang (18) besitzt; eine Schaltung die einem ersten (R1) und zweiten (R2) Widerstand und Kapazitive Mittel (C1) beeinhaltet, die in Reihe zwischen eine Potentialquelle und einem Bezugspunkt geschaltet sind, wobei der Verbindungspunkt zwischen dem zweiten Widerstand (R2) und den Kapazitiven Mitteln (C1) mit dem zweiten Eingang (16) verbunden ist; ersten Mitteln (R3, R4) zum Erstellen einer ersten Bezugsspannung an dem ersten Eingang (14), so das der Ausgang des Vergleichers (12) von einem zweiten Zustand in einen ersten Zustand wechselt, wenn eine sich progressiv in einem Sinne sich ändernde Spannung an dem zweiten Eingang (16) die erste Bezugsspannung überschreitet, wobei die ersten Mittel aus einem dritten (R3) und vierten (R4) Widerstand bestehen, die in Reihe zwischen der Potentialquelle und dem Bezugspunkt geschaltet sind, wobei der Verbindungspunkt zwischen dem dritten und vierten Widerstand mit dem ersten Eingang (14) verbunden ist; zweite Mittel (R5, CR2), die auf den ersten Zustand des Ausgangs zum Erstellen einer zweiten Bezugsspannung an dem ersten Eingang (14) ansprechen; und dritte Mittel (CR1) zum Erzeugen einer Spannung an dem zweiten Eingang (16), abhängig von dem ersten Zustand, die sich progressiv in einem Sinn entgegengesetzt zu dem einen Sinne in Richtung zur zweiten Bezugsspannung ändert, so dass der Ausgang des Vergleichers (12) auf den zweiten Zustand wechselt, wenn die Spannung an dem zweiten Eingang die zweite Bezugsspannung überschreitet, dadurch gekennzeichnet, das die zweiten Mittel einen fünften Widerstand (R5) und ersten Diodenmittel (CR2) besitzen, die in Reihe zwischen dem ersten Eingang und dem Ausgang (18) geschaltet sind; und dass die dritten Mittel zweiten Diodemittel (CR1) besitzen, die zwischen den genannten Ausgang und einem Verbindungspunkt zwischen dem ersten und dem zweiten Widerstand geschaltet sind, so dass die Ausgangsfrequenz der Intervall-Zeitgabe-Schaltung auch bei einer Veränderung der Potentialquelle konstant bleibt.

2. Schaltung nach Anspruch 1, dadurch gekennzeichnet, dass die dritte (R3), vierte (R4) und fünfte (R5) Widerstände Widerstandswerte im Verhältnis 6:12:4 besitzen.

## Revendications

1. Circuit de système chronométrique d'intervalles comprenant un comparateur (12) comportant une première (14) et une seconde (16) entrée ainsi qu'une sortie (18); un circuit comprenant première (R1) et second (R2) résistances et un condensateur (C1) montées en série entre une source de potentiel et le potentiel de référence de la masse, la jonction entre ladite seconde résistance et ledit condensateur étant connectée à ladite second entrée (16); un premier dispositif (R3, R4) d'établissement d'une première tension de référence à ladite première entrée (14) de manière que la sortie du comparateur (12) passe d'un second état à un premier lorsqu'une tension variant progressivement dans un sens à ladite seconde entrée (16) passe par ladite première tension de référence, ledit premier dispositif comprenant une troisième (R3) résistance et une quatrième (R4) résistance qui sont montées en série entre la source de potentiel et le potentiel de référence de la masse, la jonction entre lesdites troisième et quatrième résistances étant connectée à ladite première entrée (14); un second dispositif (R5, CR2) sensible audit premier état de ladite sortie étant destiné à établir une seconde tension de référence à ladite première entrée (14), et un troisième dispositif (CR1) étant destiné à produire à ladite seconde entrée (16), en réponse à la présence dudit premier état, une tension qui varie progressivement en sens opposé audit sens mentionné vers ladite seconde tension de référence, de manière que la sortie dudit comparateur (12) passe audit second état lorsque ladite tension appliquée à ladite seconde entrée passe par la seconde tension de référence, circuit caractérisé en ce que ledit second dispositif comprend une cinquième résistance (R5) et une première diode (CR2) montées en série entre ladite première entrée et la sortie (18); et en ce que ledit troisième dispositif comprend une seconde diode (CR1), montée entre ladite sortie et une jonction entre lesdites première et seconde résistances, donc la fréquence de sortie du circuit de système chronométrique d'intervalles se maintient stable même s'il y a une variation dans la source de potentiel.

2. Circuit selon la revendication 1, caractérisé en ce que lesdites troisième (R3), quatrième (R4) et cinquième (R5) résistances ont des valeurs qui sont dans le rapport 6:12:4.

FIG. 1

FIG. 2A

FIG. 2B

OUTPUT FROM
CIRCUIT 10